# EUROPEAN PATENT SPECIFICATION

(11) **EP 2 644 754 B1**
(45) Date of publication and mention of the grant of the patent: **11.05.2016**
(21) Application number: 11843419.0
(22) Date of filing: 22.11.2011
(51) Int. Cl.: C25D 7/06, C23C 28/00, C25D 5/10, H05K 1/09

(54) **SURFACE TREATED COPPER FOIL**
OBERFLÄCHENBEHANDELTE KUPFERFOLIE
FEUILLE DE CUIVRE TRAITÉE EN SURFACE

(30) Priority: 22.11.2010 JP 2010260369; 19.07.2011 JP 2011158177
(43) Date of publication of application: 02.10.2013
(73) Proprietor: MITSUI MINING & SMELTING CO., LTD., Tokyo 141-8584 (JP)
(72) Inventor: OBATA, Shinichi, Ageo-shi, Saitama 362-0017 (JP); HIRAOKA, Shinya, Ageo-shi, Saitama 362-0017 (JP); HOSOKOSHI, Fumiaki, Ageo-shi, Saitama 362-0017 (JP); TATEOKA, Ayumu, Ageo-shi, Saitama 362-0017 (JP); MATSUSHIMA, Hideaki, Ageo-shi, Saitama 362-0021 (JP); MIYAKE, Koichi, Ageo-shi, Saitama 362-0021 (JP); TOMONAGA, Sakiko, Ageo-shi, Saitama 362-0021 (JP); MAEDA, Tomoyuki, Ageo-shi, Saitama 362-0021 (JP)
(74) Representative: Vossius & Partner Patentanwälte Rechtsanwälte mbB
(86) International application number: PCT/JP2011/076955
(87) International publication number: WO 2012/070589

(56) References cited:
- EP-A1- 1 175 132
- JP-A- 7 054 183
- JP-A- H04 501 887
- JP-A- 2003 201 585
- JP-A- 2005 350 761
- JP-A- 2006 052 441
- JP-A- 2008 101 267
- JP-A- 2009 164 488
- JP-A- 2009 221 592
- JP-A- 2010 037 654
- US-A1- 2004 191 560
- US-A1- 2006 257 680

## Description

### [Technical Field]

The present invention relates to a surface-treated copper foil, and a method for manufacturing the surface-treated copper foil. In particular, an object of the present invention is to provide a surface-treated copper foil which decreases less physical strength after heat treatment at temperature exceeding 300°C.

### [Background Art]

Current copper foils are used not only in printed wiring board applications but as a constituting material of various types of electronic devices. With regard to the electronic devices in recent years, miniaturization is required and heat resistance against heat generation in operation of the devices is required also. Therefore, for materials constituting the electronic devices, heat resistance against high heats loaded in processing is required to improve qualities of electronic devices as final products.

For example, patent document 1 discloses object in copper foils for application in the printed wiring board technology to provide a metal-clad laminate which ensures a sufficient strength to form a stable flying lead and is applicable to a usage where fine pattern formation by using an electro-deposited copper foil. In the patent document 1, a technology in which "The metal clad laminate is formed by laminating a copper foil layer formed by the electro-deposited copper foil, a polyimide resin layer, and a stainless foil layer in this order; the average of grain size in crystal grains of copper constituting the copper layer is in the range of 0.5 to 3.0 µm, and further, difference between the average value and the maximum value of particle diameters in crystal grains is within a range of 2.0 µm or less " is disclosed. Further, in the descriptions in Claim 2 and the columns 0022 to 0024 of the patent document 1, the matter is disclosed that properties including the grain size of the crystal grains of the copper foil and physical strength as tensile strength of 400 MPa or more are necessary when improvement of the ultrasonic resistance of wiring (made of the copper foil) in the flying leads formed is investigated. Furthermore, as can be understood in the descriptions in Patent document 1, the matter is apparent that the physical strength of flying leads formed of a copper foil is required to be high even after loading a certain heat history.

Also in other technical fields, a copper foil after loading a certain heat history may be required to ensure excellent physical performance. For example, when a copper foil is used for a negative electrode current collector of a lithium ion secondary battery, the copper foil constituting the negative electrode current collector is loaded repeating expansion and contraction of an active substance provided on a negative electrode current collector.

For example, patent document 2 employs a technology to provide a current collector having high tensile strength at low cost regardless of its thin thickness that "The negative electrode current collector is characterized in being provided with a hard nickel plating layer formed on at least one surface of an electro-deposited foil composed of metal material having low possibility in generation of lithium compounds. The hard plated nickel layer is formed by applying electro-plating using a plating bath containing nickel, nickel salt and ammonium.salt. The metal material may be an alloy of two or more selected from copper, iron, cobalt, nickel, zinc and silver, for example". Then patent document 2 discloses that a current collector which ensures sufficiently high tensile strength even after heat treatment can be produced when the electro-deposited foil is used.

Patent document 3 discloses "The composite foils provided with a cobalt plating layer or a cobalt-nickel alloy plating layer on a surface of a copper foil are employed as a metallic foil for the negative electrode current collector of the nonaqueous electrolyte secondary batteries" to provide a composite foil which has high tensile strength even after high heat treatment and is suitably used as a negative electrode current collector of nonaqueous electrolyte secondary batteries.

Patent document 4 discloses a specific copper foil for a printed circuit board comprising a copper foil composed of copper or copper alloy and having a surface to be faced to a base material for a printed circuit board; a zinc galvanized layer provided on the bonding surface; and a trivalent chromate treatment layer directly formed on the zinc galvanized layer.

Patent document 5 relates to an electrolytic copper foil produced by electrolyzing a copper electrolysis solution, which contains 110 ppm to 400 ppm of sulfur, 150 ppm to 650 ppm of chlorine and has an electric conductivity of ≥48% IACS and an ordinary tensile strength of ≥70 kgf/mm² (≥686 N/mm²).

### [Documents Cited]

### [Patent Documents]

[Patent document 1] Japanese Patent Laid-Open No. 2009-289313
[Patent document 2] Japanese Patent Laid-Open No. 2005-197205
[Patent document 3] Japanese Patent Laid-Open No. 2005-350761
[Patent document 4] US Patent Application No. 2006/257680
[Patent document 5] Japanese Patent Laid-Open No. 2009-221592

### [Summary of the Invention]

### [Problems to be Solved]

As described above in the printed wiring board industry in recent years, a copper foil and an insulating resin base material are laminated using a heating temperature exceeding 300°C in many case including manufacturings of flexible printed wiring board by the casting method, heat-resistant substrates, and substrates for high-frequency application. As a result, a copper foil hardly softening after loading high heat has been required because various problems due to decreased physical strength of the copper foil as a result of loading of high heat on the copper foil used in these applications has arisen.

Also in the lithium ion secondary battery applications in recent years, temperature of about 350°C to 400°C is loaded in manufacturing of a negative electrode to provide a negative electrode active substance on the surface of a copper foil as a current collector by heating. Furthermore, the negative electrode current collector is loaded by stresses of expansion/contraction caused in charge/discharge operation as a lithium ion secondary battery. Therefore, the requirement on a copper foil which ensures a proper strength after heat treatment has become further severe.

As can be understood from the descriptions above, an object of the present invention is to provide a copper foil excellent in softening resistance performance to reduce decrease in tensile strength after heat treatment at a temperature of about 350°C to 400°C.

### [Means to Solve the Problem]

Then, as a result of intensive studies, the inventors of the present invention have thought out a surface-treated copper foil which is not expensive and reduces decrease in tensile strength after heat treatment by employing the following technical concept.

### [Surface-treated copper foil according to the present invention]

The surface-treated copper foil according to the present invention is a surface-treated copper foil which is provided with a rust-proofing treatment layer on both surfaces of a copper foil and the rust-proofing treatment layer is constituted by zinc, the rust-proofing treatment layer on each surface is a zinc layer having a zinc amount of 20 mg/m² to 1,000 mg/m²; and the copper foil contains one or two or more of small amount elements selected from carbon, sulfur, chlorine and nitrogen, and has a sum amount thereof of 100 ppm or more.

In the surface-treated copper foil according to the present invention, the sum amount of zinc constituting the zinc layers provided on both surfaces of the copper foil is preferable to be 40 mg/m² to 2,000 mg/m².

In the surface-treated copper foil according to the present invention, it is preferable to constitute the rust-proofing treatment layer by a zinc-based composite layer of a two-layer structure provided with a different metal layer selected from tin layer, cadmium layer, antimony layer, bismuth layer, indium layer and lead layer between the copper foil and the zinc layer, or on a surface of the zinc layer.

Then, it is preferable that the different metal layer is the layer containing the different metal component of 1 mg/m² to 200 mg/m².

In the surface-treated copper foil according to the present invention, it is preferable that the copper foil is an electro-deposited copper foil having a grain size as received of 1.0 µm or less.

In the surface-treated copper foil according to the present invention, it is preferable that the copper foil is an electro-deposited copper foil having tensile strength as received of 50 kgf/mm² (490 N/mm²) or more.

In the surface-treated copper foil according to the present invention, it is preferable that the copper foil is provided with a roughening treatment on one surface or both surfaces.

In the surface-treated copper foil according to the present invention, it is preferable that the rust-proofing treatment layer is provided with one or both of a chromate-treatment layer and an organic agent-treatment layer on the surface.

In the surface-treated copper foil according to the present invention, it is preferable that the organic agent-treatment layer is one or both of a silane coupling agent-treatment layer and an organic rust-proofing treatment layer.

In the surface-treated copper foil according to the present invention, surface roughness (Ra) of the surface treated copper foil is preferable to be 0.1 µm to 0.7 µm.

The surface-treated copper foil according to the present invention is excellent in physical strength, tensile strength of 40 kgf/mm² (392 N/mm²) or more after heat treatment at 350°C for 60 min in an inert gas atmosphere.

The surface-treated copper foil according to the present invention is excellent in physical strength, tensile strength of 35 kgf/mm² (343 N/mm²) or more after heat treatment at 400°C for 60 min in an inert gas atmosphere.

### [Advantages of the Invention]

The surface-treated copper foil according to the present invention employs zinc layer or zinc-based composite layer of a two-layer structure described above as a rust-proofing treatment layer. As a result, the surface-treated copper foil is excellent in physical strength, tensile strength of 40 kgf/mm² (392 N/mm²) or more even after heat treatment at 350°C for 60 min in an inert gas atmosphere. Further, the surface-treated copper foil is excellent in physical strength after heat treatment,' tensile strength of 35 kgf/mm² (343 N/mm²) or more even after heat treatment at 400°C for 60 min in an inert gas atmosphere. In the surface-treated copper foils for general use, tensile strength may be 40 kgf/mm² (392 N/mm²) or less after heat treatment at 350°C for 60 min in an inert gas atmosphere, and tensile strength may be 35 kgf/mm² (343 N/mm²) or less after heat treatment at 400°C for 60 min. In view of these facts, the surface-treated copper foil according to the present invention has remarkably excellent softening resistance performance against heating as a copper foil.

### [Brief Description of Drawings]

[Figure 1] Figure 1 is a schematic cross-sectional diagram to grasp a typical image of the surface-treated copper foil according to the present invention.
[Figure 2] Figure 2 is cross-sectional FIB-SIM images of grain structures in the surface-treated copper foil according to the present invention and another surface-treated copper foil.
[Figure 3] Figure 3 is a cross-sectional FIB-SIM image of grain structures in a reference specimen described in Table 2 used for comparison with Example 2.
[Figure 4] Figure 4 is a cross-sectional FIB-SIM image of a grain structure of a specimen 2-2 in Example 2.
[Figure 5] Figure 5 is a cross-sectional FIB-SIM image of a grain structure of comparative specimen 2-2 in Comparative Example 2.
[Figure 6] Figure 6 is a cross-sectional FIB-SIM image of a grain structure of comparative specimen 3 in Comparative Example 3.
[Figure 7] Figure 7 is a cross-sectional FIB-SIM image of a grain structure of a specimen 3-1 in Example 3.
[Figure 8] Figure 8 is a cross-sectional FIB-SIM image of a grain structure of a specimen 3-6 in Example 3.

### [Detailed Description of Embodiments]

Hereinafter, embodiments of the surface-treated copper foil and the method for manufacturing the surface-treated copper foil according to the present invention will be described in detail.

### [Embodiment of the surface-treated copper foil according to the present invention]

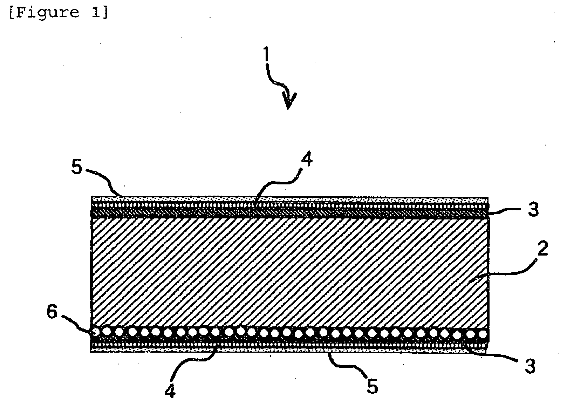

The surface-treated copper foil according to the present invention is a surface-treated copper foil in which a rust-proofing treatment layer is provided on each of both surfaces of a copper foil, as schematically shown in Figure 1. In Figure 1, a typical structure is exemplified in which a surface-treatment layer of a three-layer structure of "a rust-proofing treatment layer 3 / a chromate-treatment layer 4 / an organic agent-treatment layer 5" is provided on one surface of the copper foil 2, and a surface-treatment layer of a four-layer structure of "a roughening treatment layer 6 / a rust-proofing treatment layer 3 / a chromate-treatment layer 4 / an organic agent-treatment layer 5" is provided on the other surface. Note that, the roughening treatment layer shown is an aggregated fine copper particle. Next, the roughening treatment layer 6, the chromate-treatment layer 4 and the organic agent-treatment layer 5 in Figure 1 are optional surface-treatment layers provided depending on the required performance. Therefore, many variations in the layer structures are included in the present invention. By the way, the matter should be clearly noted that schematically shown each layer and a roughened state in the drawing is example for easy recognition, i.e. the drawing does not reflect the thickness and the roughened state of an actual product. Hereinafter, to make understanding of the constitution of the surface-treated copper foil according to the present invention easy, each item will be described one by one.

Copper foil: As for a "copper foil" here, a copper foil is used which contains one or two or more selected from small amount elements including carbon, sulfur, chlorine and nitrogen, and having a sum amount thereof of 100 ppm or more. This is because when the copper foil contains carbon, sulfur, chlorine or nitrogen described above and has at least a sum amount thereof of 100 ppm or more, the copper foil exhibits excellent physical strength. Therefore, the copper foil may be a rolled copper foil or an electro-deposited copper foil as long as it contains the small amount elements. Note that, the words "copper foil" refers to an untreated copper foil which is not provided with surface treatment including a roughening treatment and a rust-proofing treatment.

In addition to the specification of "a sum amount of carbon, sulfur, chlorine and nitrogen of 100 ppm or more", the following specification is preferably satisfied for each component. In the copper foil used in manufacturing of a surface-treated copper foil according to the present invention, an electro-deposited copper foil is more preferable to contain sulfur in the range of 5 ppm to 600 ppm, carbon in the range of 20 ppm to 470 ppm, nitrogen in the range of 5 ppm to 180 ppm, and chlorine in the range of 15 ppm to 600 ppm. Proper amounts of small amount elements contained in the grain structure of a copper foil make a grain size of the electro-deposited copper foil 1.0 µm or less and provide excellent tensile strength as received of 50 kgf/mm² (490 N/mm²) or more to the copper foil. The excellent physical strength of the electro-deposited copper foil is achieved mainly by the miniaturization effect of crystal grains. Next, the elongation as received of such a copper foil might be in the range of 3% to 15%. It should be noted that the unit "ppm" indicting the content of a component is equivalent to "mg/kg". Hereinafter, carbon, sulfur, chlorine and nitrogen described above excluding copper contained in a copper foil not provided with surface treatment may be referred to simply as "small amount elements". Hereinafter, meaning in specification of the content range for each small amount element will be described one by one.

When sulfur content in a copper foil is less than 5 ppm, excellent physical strength through miniaturization of crystal grains is hardly achieved because it is hard to make the grain size as received described later 1.0 µm or less. So, it is not preferable. In contrast, when sulfur content in an electro-deposited copper foil exceeds 600 ppm, although tensile strength of the electro-deposited copper foil is made high, elongation decreases to be brittle. So, it is not preferable.

When carbon content in a copper foil is less than 20 ppm, formation of graphite which makes the electro-deposited copper foil texture excellent in physical strength may be made poor and an excellent physical strength may be hardly achieved. So, it is not preferable. In contrast, when carbon content in an electro-deposited copper foil exceeds 470 ppm, graphite grows too big and cracks may easily generate. So, it is not preferable.

When nitrogen content in a copper foil is less than 5 ppm, formation of nitrogen compound which makes the electro-deposited copper foil texture excellent in physical strength may be poor and an excellent physical strength may be hardly achieved. So, it is not preferable. In contrast, when nitrogen content in an electro-deposited copper foil exceeds 180 ppm, the nitrogen compound may be excessive and the effect of making physical strength excellent by a deposit texture in the electro-deposited copper foil saturates. So, it is not preferable because the significance of increasing the nitrogen content is lost.

When chlorine content in a copper foil is less than 15 ppm, formation of a chloride which makes the electro-deposited copper foil texture excellent in physical strength may be poor and chlorine cannot contribute to make physical strength excellent. So, it is not preferable. In contrast, when chlorine content in an electro-deposited copper foil exceeds 600 ppm, the deposit surface of the electro-deposited copper foil is made rough and the electro-deposited copper foil having a low profile surface cannot be obtained. So, it is not preferable because the electro-deposited copper foil is hardly used as a copper foil for formation of fine pitch circuits.

The small amount elements contained in a copper foil described above react with zinc which is a rust-proofing component described later and diffused into the grain structure of the copper foil. As a result, re-crystallization of the grain structure in heat treatment of the surface-treated copper foil according to the present invention is hindered, and the fine crystal grains are prevented from becoming coarse.

Next, uneven deposit surface is made smooth because particle size of crystal grains constituting the grain structure of the electro-deposited copper foil is fine and uniform. Because of such fine grain size, the surface roughness of the deposit surface of the electro-deposited copper foil is very low, i.e. low profile surface is achieved.

Thickness of a copper foil used here may be appropriately arranged depending on applications of the surface-treated copper foil. So, it is not especially limited. For example, in the printed wiring board applications, the copper foil is used in the gauge thickness range of 5 µm to 120 µm in many cases. In the negative electrode current collector of lithium ion secondary batteries, the copper foil in the gauge thickness range of 5 µm to 35 µm is used in many cases.

Further, physical strength of a copper foil before providing a rust-proofing treatment layer will be investigated. The copper foil is preferable to have following physical strength in order to satisfy the performance required on a surface-treated copper foil. In order to ensure tensile strength at 40 kgf/mm² (392 N/mm²) or more after heat treatment at 350°C for 60 min when a copper foil is surface-treated to have a rusty-proofing treatment layer, tensile strength of the copper foil as received is preferable to be 50 kgf/mm² (490 N/mm²) or more. If further enhanced tensile strength of 40 kgf/mm² (392 N/mm²) or more after heat treatment as the surface-treated copper foil is ensured, tensile strength of the copper foil as received is preferable to be 60 kgf/mm² (588 N/mm²) or more.

Rust-proofing treatment layer: In the present invention, zinc layer to be formed on the surface of a copper foil is provided on each of both surfaces and the zinc amount of each surface is 20 mg/m² to 1,000 mg/m². By providing the zinc layers in such a manner, softening resistance performance against heating of an electro-deposited copper foil is improved, and decrease in tensile strength after heat treatment is hindered.

When the zinc amount is less than 20 mg/m², softening resistance performance against heating is not enhanced and tensile strength after heat treatment decreases. So, it is not preferable. In contrast, when the zinc amount exceeds 1,000 mg/m², because the effect on enhancing of softening resistance performance against heating may be saturated when the heating is carried out in a level at 350°C for 60 min to 400°C for 60 min, the resource is wasted. So, it is not preferable. Therefore, in consideration of the zinc amounts on one surface side of the surface-treated copper foil according to the present invention and the zinc amount on the other surface side together, the sum amount of zinc constituting the zinc layers provided on both surfaces of the copper foil is preferable to be 40 mg/m² to 2,000 mg/m². The zinc amount here is a calculated amount per unit area.

The calculated amount is determined as amount of a rust-proofing component per unit area on the assumption that the copper foil surface is ideally flat. The words "zinc amount" used in the present description refers to amount of zinc in the whole of a rust-proofing treatment layer.

Further in the surface-treated copper foil according to the present invention, the case in which zinc-based composite layer of a two-layer structure is employed as a rust-proofing treatment layer by providing any one different metal layer of tin layer, cadmium layer, antimony layer, bismuth layer, indium layer, and lead layer between the copper foil and the zinc layer or on the surface of the zinc layer will be described. In the surface-treated copper foil in which such zinc-based composite layer of a two-layer structure is provided as a rust-proofing treatment layer, decreasing ratio of tensile strength after heat treatment may be further reduced than in a surface treated copper foil in which zinc layer alone is provided. When a zinc-based composite layer has the two-layer structure, amount of the different metal component constituting different metal layer provided on either surface of the copper foil is preferable to be in the range of 1 mg/m² to 200 mg/m², in addition to the specification that the zinc amount as a rust-proofing component provided on each surface of a copper foil is 20 mg/m² to 1,000 mg/m² as described above.

A metal element used for the different metal layer is one selected from elements satisfying any of the following specifications. That is, the elements having larger diffusion coefficient than zinc in copper at 300°C or more (for example, Bi, Cd, Sn, Pb, Sb, In, Al, As, Ga, Ge), elements having lower melting point than zinc (for example, Bi, Cd, Pb, Sn, In, Ga, Li), or elements showing lower eutectic temperature than zinc when alloyed with zinc (for example, Bi, Cd, Sn, Pb, Sb, Ni, Ba, Ca, In, Al, As, Ga, Ge, Mg, Mn). This is because the coexistence of these elements with zinc in the grain structure of a copper foil may promote formation of compounds which contributes to excellent physical strength.

When content of the different metal component provided is less than 1 mg/m², softening resistance performance against heating is not improved and tensile strength after heat treatment is not improved than the case of zinc layer alone. So, it is not preferable because the significance of providing different metal layer is lost. In contrast, when content of the different metal component provided exceeds 200 mg/m², the etching performance of a copper foil when subjected to an etching processing to form circuits is made poor, and simultaneously, the effect of improving softening resistance performance when the copper foil is heated in a level at 350°C for 60 min to 400°C for 60 min saturates. So, it is not preferable because the resource is wasted. Note that the content of the different metal component provided indicates a calculated amount per unit area as in the case of the zinc amount also, i.e. the calculated amount is determined as a content of different metal component in a unit area where the copper foil is ideally flat.

When zinc-based composite layer of a two-layer structure described above is employed, it is preferable to arrange the thicknesses of different metal layer and zinc layer to satisfy the relationship of [different metal content]/[zinc amount] = 1/100 to 1/2 in weight ratio between content of the different metal component in the different metal layer and content of the zinc component in the zinc layer constituting a rust-proofing treatment layer. When the weight ratio is lower than 1/100, amount of the different metal component is too small not to improve softening resistance performance against heating. SO, it is not preferable because the significance of providing different metal layer is lost. When the weight ratio exceeds 1/2, the diffusion of zinc into the grain structure of a copper foil is hindered and softening resistance performance against heating is hardly improved because amount of the different metal component is too excessive against the zinc amount and the zinc amount relatively decreases in a rust-proofing treatment layer.

When the zinc-based composite layer of a two-layer structure is employed as a rust-proofing treatment layer, counter diffusion of zinc and different metal component occurs between zinc layer and different metal layer in contact by heating in press lamination of a copper-clad laminate or by heating in a negative electrode material manufacturing process of a lithium ion secondary battery, and form an alloy layer of zinc-different metal. As a result, the same effect as in the case of a rust-proofing treatment layer originally formed of zinc-different metal alloy is achieved. The order for stacking zinc layer and different metal layer is not especially limited, but it is preferable that the different metal layer is provided between a copper foil and the zinc layer. This is because zinc and the different metal component counter diffuse when a surface-treated copper foil is heated; the diffusion causes a certain concentration gradient in the zinc layer and the different metal layer to provide high zinc concentration at the utmost surface layer; and a stable rust-proofing performance by zinc may be achieved easily.

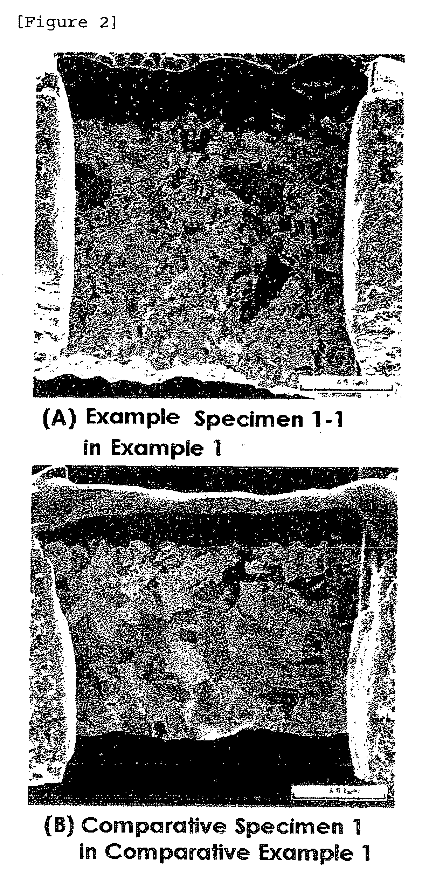

Next, grain structures of surface-treated copper foils after heat treatment at 350°C for 60 min in an inert gas atmosphere will be investigated with reference to Figure 2. Figure 2(A) shows a surface-treated copper foil corresponding to the example specimen 1-1 in Example 1 according to the present invention. In contrast, Figure 2(B) shows a surface-treated copper foil corresponding to comparative specimen 1 of Comparative Example 1 in the present application, i.e. the copper foil is not included in the surface-treated copper foil according to the present invention. As can be understood from Figure 2, the grain structure in Figure 2(A) maintains finer crystal grains after heat treatment at 350°C for 60 min than the grain structure in Figure 2(B). That is, the matter can be understood that when a "copper foil having a sum amount of one or two or more of small amount elements selected from carbon, sulfur, chlorine and nitrogen of 100 ppm or more" is used, and when at least two specifications "one of zinc layer or zinc-based composite layer of a two-layer structure is used" and "the zinc amount is made to be in the range of 20 mg/m² to 1,000 mg/m²" are satisfied in the rust-proofing treatment layer, the crystal grains are not made coarse and the effect of maintaining fine crystal grains is achieved even when high heat is loaded.

Roughening treatment on the copper foil surface: A roughening treatment on the copper foil surface will be described. The roughening treatment is provided between a copper foil and the above-mentioned rust-proofing treatment layer in general. In the copper foil used for the surface-treated copper foil according to the present invention, it is preferable to provide a roughening treatment on one surface or both surfaces. Next, whether the roughening treatment is provided on only one surface of the copper foil or both surfaces may appropriately be judged depending on applications of the surface-treated copper foil. When the surface-treated copper foil is used for manufacturing of a printed wiring board, the surface provided with roughening treatment enhance adhesion to an insulating resin base material as a constituting material of the printed wiring board. When the surface-treated copper foil is used as a negative electrode current collector of a lithium ion secondary battery, the roughening treated surface of the negative electrode current collector enhances adhesion to a negative electrode active substance.

As for the roughening treatment, the method for roughening treatment, the roughening treatment condition and the like are not especially limited. Therefore, a method of depositing and forming fine metal particles on the copper foil surface, a method of etching the copper foil surface to make the surface rough, a method of depositing and forming a metal oxide, or the like can be employed.

Other surface treatments: In the surface-treated copper foil according to the present invention, it is preferable that one or both of a chromate-treatment layer and an organic agent-treatment layer is provided on the surface of the rust-proofing treatment layer whether roughening treatment is provided or not. These surface treatments achieve further good adhesion to "insulating resin base material of a printed wiring board" and "negative electrode active substance of a lithium ion secondary battery" contact with the rust-proofing treatment layer.

The organic agent-treatment layer is a silane coupling agent-treatment layer and an organic rust-proofing treatment layer, and one or both of these layers may be provided. When both layers are provided, order of providing the silane coupling agent-treatment layer and the organic rust-proofing treatment layer may appropriately be judged in consideration of the required performance of a surface-treated copper foil. Components constituting the silane coupling agent-treatment layer and the organic rust-proofing treatment layer will be described in detail later.

Surface roughness of the copper foil: In the surface-treated copper foil according to the present invention, surface roughnesses (Ra) of both surfaces measured by the procedure provided in JIS B0601 are preferable to be 0.1 µm to 0.7 µm. When the surface roughness (Ra) of a copper foil is lower than 0.1 µm, adhesion with an "insulating resin base material of a printed wiring board" and a "negative electrode active substance of a lithium ion secondary battery" cannot be secured in a practical use. So, it is not preferable. When the surface roughness (Ra) of a copper foil exceeds 0.7 µm, formation of fine pitch circuits in a 50-µm pitch level is made difficult. Next, when the copper foil is used as a negative electrode current collector of a lithium ion secondary battery, valley portions in the irregularity of the surface roughness may trigger generation of microcracks in expansion/contraction behavior of the copper foil. So, it is not preferable.

Physical strength of the surface-treated copper foil: In the surface-treated copper foil according to the present invention, tensile strength after heat treatment as the physical strength is paid attention. Hereinafter, tensile strength will be described.

The copper foil according to the present invention has excellent tensile strength as high as 40 kgf/mm² (392 N/mm²) or more after heat treatment at 350°C for 60 min in an inert gas atmosphere. Next, the reason why a temperature of 350°C is employed will be described. In the field relating to a printed wiring board, as many cases exist where a copper foil and an insulating resin base material are laminated at temperature exceeding 300°C including manufacturings of flexible printed wiring boards produced by the casting method, heat-resistant substrates and high-frequency substrates, softening resistance performance of the copper foil after heat treatment is discussed in some cases. Also in the field relating to lithium ion secondary battery, when a negative electrode active substance is heated and provided on the surface of a copper foil as a current collector in manufacturing of a negative electrode, heating temperature may be about 350°C to 400°C.

As can be understood from descriptions above, in the case of the lithium ion secondary battery, the copper foil is preferable to have high tensile strength even after heat treatment at 400°C for 60 min when heating temperature in manufacturing of the negative electrode is considered. To answer the requirement, the surface-treated copper foil according to the present invention exhibits tensile strength of 35 kgf/mm² (343 N/mm²) or more after heat treatment at the temperature as a physical strength. It is apparent that the surface-treated copper foil according to the present invention has remarkably high value of tensile strength after heat treatment at 400°C for 60 min as compared with conventional copper foils.

### [Embodiment of manufacturing of the surface-treated copper foil according to the present invention]

A method for manufacturing the surface-treated copper foil according to the present invention is a method for manufacturing the above-mentioned surface-treated copper foil including a rust-proofing treatment step for providing a "zinc layer" or a "zinc-based composite layer of a two-layer structure" as a rust-proofing treatment layer on the surface of a copper foil; and the method further includes various types of surface treatments including a roughening treatment according to needs, and a drying step for heating.in a predetermined condition. Hereinafter, each step will be described one by one.

Preparation of a copper foil: As can be understood from the descriptions above, a copper foil is used which satisfies specification, "foil contains carbon, sulfur, chlorine or nitrogen, and at least the sum amount thereof is 100 ppm or more". Further, it is more preferable to selectively use an electro-deposited copper foil which also satisfies specification, "a grain size as received of 1.0 µm or less" and "tensile strength as received of 50 kgf/mm² (490 N/mm²) or more" as the copper foil. In Examples described later, an electro-deposited copper foil without surface treatment for manufacturing of a VLP copper foil produced by Mitsui Mining & Smelting Co., Ltd. which contains above-mentioned small amount elements were used as a copper foil satisfying these specifications.

Roughening treatment on the copper foil surface: It should be clearly noted first that the roughening treatment is not an indispensable step but an optional step. The roughening treatment can be carried out on one surface or both surfaces of a copper foil depending on application of the surface-treated copper foil. Hereinafter, a method of a roughening treatment will be described. Before the roughening treatment, it is preferable to carry out cleaning of the copper foil surface by an acid rinsing treatment or the like.

The roughening treatment method is not especially limited, but one example will be described below. First, fine copper particles are deposited and formed on a copper foil surface using a sulfuric acid-based copper electrolytic solution having copper concentration of 5 g/l to 25 g/l and free sulfuric acid concentration of 50 g/l to 250 g/l, and as required, a gelatin is added as an additive, under a burning plating condition at solution temperature of 15°C to 30°C and cathode current density of 20 A/dm² to 50 A/dm². Then, the fine copper particles are fixed by using a sulfuric acid-based copper electrolytic solution having copper concentration of 45 g/l to 100 g/l and free sulfuric acid concentration of 50 g/l to 150 g/l, under a level plating condition at solution temperature of 30°C to 50°C and cathode current density of 30 A/dm² to 60 A/dm² to finish the roughening treatment.

Formation of a rust-proofing treatment layer: In the present invention, a "zinc layer" or a "zinc-based composite layer of a two-layer structure" is provided as a rust-proofing treatment layer on both surfaces of a copper foil. In formation of the rust-proofing treatment layer, any method for forming the rust-proofing treatment layer can be employed as long as the zinc amount of each surface of the copper foil is made in the range of 20 mg/m² to 1,000 mg/m² as described above. That is, for formation of a rust-proofing treatment layer on a copper foil surface, an electrochemical technology such as electrolytic plating method or electroless plating method, or a physical vapor-deposition method such as sputtering vapor-deposition or a chemical gas-phase reaction can be used. However, it is preferable to employ an electrochemical method in consideration of the production cost.

When zinc layer composed of zinc is provided using an electrolytic plating method will be described. A plating solution including zinc pyrophosphate plating bath, zinc cyanide plating bath and zinc sulfate plating bath can be used. In the detail of the zinc pyrophosphate plating bath, zinc layer can be formed on a copper foil surface by employing a bath composition, zinc concentration of 5 g/l to 30 g/l, a potassium pyrophosphate concentration of 50 g/l to 500 g/l, and pH 9 to pH 12, and electrolysis is carried out in the solution cathodically polarizing a copper foil with solution temperature of 20°C to 50°C under current density of 0.3 A/dm² to 10 A/dm².

Next, when a "zinc-based composite layer of a two-layer structure" composed of zinc layer and different metal layer is provided using an electrolytic plating method will be described. In this case, in order to provide the different metal layer between a copper foil and the zinc layer or on the surface of the zinc layer, "any one layer of tin layer, cadmium layer, antimony layer, bismuth layer, indium layer and lead layer" is first provided on the surface of the copper foil by an electrolytic plating method. Then, the zinc layer is provided on the different metal layer. As a formation method of the zinc layer, the same method as described above can be employed. Hereinafter, formation methods of different metal layers including "tin layer", "cadmium layer", "antimony layer", "bismuth layer", "indium layer" and "lead layer", will be described.

When tin layer is provided as the different metal layer, any conditions including plating solutions usable as a tin plating solution and plating conditions can be used. For example, conditions include "using stannous sulfate, and tin concentration of 5 g/l to 30 g/l, solution temperature of 20°C to 50°C, pH of 2 to 4, and current density of 0.3 A/dm² to 10 A/dm²" and "using starinous sulfate, and tin concentration of 20 g/l to 40 g/l, a sulfuric acid concentration of 70 g/l to 150 g/l, a cresol sulfonate concentration of 70 g/l to 120 g/l, a gelatin concentration of 1 g/l to 5 g/l, a β-naphthol concentration of 0.5 g/l to 2 g/l, solution temperature of 20°C to 35°C, and current density of 0.3 A/dm² to 3 A/dm²".

When cadmium layer is provided as the different metal layer, any conditions including plating solutions usable as a cadmium plating solution and plating conditions can be used. For example, plating solutions includes cadmium cyanide bath, cadmium borofluoride bath and cadmium sulfate bath. In the condition using "cadmium cyanide bath", cadmium concentration of 20 g/l to 50 g/l, solution temperature of 20°C to 30°C, and current density of 1 A/dm² to 6 A/dm² can be exemplified. And in the condition using "cadmium sulfate bath", cadmium concentration of 5 g/l to 50 g/l, solution temperature of 20°C to 50°C, and current density of 0.2 A/dm² to 5 A/dm² can be exemplified.

When antimony layer is provided as the different metal layer, any conditions including plating solutions usable as an antimony plating solution and plating conditions can be used. For example, in the condition using known potassium antimonyl tartrate bath, conditions include antimony concentration of 10 g/l to 50 g/l, solution temperature of 30°C to 50°C, and current density of 0.2 A/dm² to 1 A/dm².

When bismuth layer is provided as the different metal layer, plating solutions usable as a bismuth plating solution and plating conditions can be used. For example, conditions include use of bismuth sulfate, and bismuth concentration of 2 g/l to 5 g/l, solution temperature of 30°C to 50°C, and current density of 0.05 A/dm² to 1 A/dm² can be exemplified.

When indium layer is provided as the different metal layer, any conditions including plating solution usable as an indium plating solution and plating conditions can be used. For example, conditions include indium borofluoride bath and indium sulfate bath, and for the "indium sulfate bath", indium concentration of 20 g/l to 35 g/l, solution temperature of 20°C to 40°C, and current density of 0.5 A/dm² to 4 A/dm² can be exemplified.

When lead layer is provided as the different metal layer, any conditions including plating solutions usable as a lead plating solution and plating conditions can be used. For example, conditions include lead borofluoride concentration of 250 g/l to 400 g/l, a hydrofluoroboric acid concentration of 30 g/l to 50 g/l, a boric acid concentration of 10 g/l to 30 g/l, a glue concentration of 0.1 g/l to 0.5 g/l, a β-naphthol concentration of 0.1 g/l to 1.0 g/l, solution temperature of 25°C to 50°C, and current density of 1 A/dm² to 5 A/dm².

Method of a chromate treatment: Formation of the chromate-treatment layer is not indispensable, and is a treatment carried out suitably in consideration of the rust-proofing performance required for the copper foil. The chromate treatment includes an electrolytic chromate treatment and an electroless chromate treatment, but either one may be used. However, when deviation of the thickness in a chromate film, the stability of the deposition amount and the like are considered, the electrolytic chromate treatment is more preferable. The electrolysis condition of the electrolytic chromate treatment is not especially limited, but it is preferable to use a chromate solution having chromic acid concentration of 2 g/l to 7 g/l, and pH of 10 to 12, with electrolysis condition of solution temperature of 30°C to 40°C and current density of 1 to 8 A/dm² to uniformly coat the surface of an electro-deposited copper foil with a chromate-treatment layer.

Method of an organic agent treatment: The organic agent treatment includes a silane coupling agent treatment and an organic rust-proofing treatment. Then, these treatments will be described one by one.

In the present invention, the silane coupling agent treatment is not indispensable, but is a treatment suitably carried out in consideration of performances required for the copper foil including adhesion with an insulating resin base material or a negative electrode active substance of a lithium ion secondary battery. A silane coupling agent is generally used as a silane coupling agent solution in which the silane coupling agent is dissolved in 0.3 g/l to 15 g/l in water as a solvent. Adsorption methods of a silane coupling agent include an immersion method, a showering method and a spraying method and are not especially limited. Any method which can form a silane coupling agent-treatment layer most uniformly through contact of a solution containing a silane coupling agent with a copper foil to adsorb the silane coupling agent in conformance to the process design may be employed.

As a silane coupling agent, any selected from an olefin-functional silane, an epoxy-functional silane, an acryl-functional silane, an amino-functional silane and a mercapto-functional silane can be used. Among these silane coupling agents, it is important to selectively use a silane coupling agent which ensures performances, i) no drawbacks in both an etching process and performances of the printed wiring board in the printed wiring board use, and ii) not spoiling the adhesion with a negative electrode active substance of a lithium ion secondary battery.

Specifically, silane coupling agents including vinyltrimethoxysilane, vinylphenyltrimethoxysilane, 3-methacryloxypropyltrimethoxysilane, 3-glycidoxypropyltrimethoxysilane, 4-glycidylbutyltrimethoxysilane, 3-aminopropyltriethoxysilane, N-2-(aminoethyl)-3-aminopropyltrimethoxysilane, N-3-(4-(3-aminopropoxy)butoxy)propyl-3-aminopropyltrimethoxysilane, imidazolesilane, triazinesilane, 3-mercaptopropyltrimethoxysilane can be used.

Next, an organic rust-proofing treatment will be described. In the present invention, the organic rust-proofing treatment is not indispensable also, but is.a rust-proofing technology used depending on the requirement in addition to a "zinc layer" or a "zinc-based composite layer of a two-layer structure" as an inorganic rust-proofing treatment described above. Organic agents including benzotriazoles such as methylbenzotriazole (tollyltriazole), aminobenzotriazole, carboxybenzotriazole, and benzotriazole can be used for the organic rust-proofing treatment. Also, other organic agents including aliphatic carboxylic acids, alkylamines, benzoic acids, imidazoles, and triazinethiols can be used. One or two or more of these organic agents are used after dissolving or dispersing in solvents including water, an organic solvent or a mixture thereof.

An organic rust-proofing layer is formed on the outermost surface of a copper foil by using an organic rust-proofing agent described above. To provide an organic rust-proofing layer on the copper foil, methods including a step to prepare the solution in which an organic rust-proofing agent described above is dissolved in a solvent such as water or an organic solvent, followed by means including, immersion, shower, spray or drop the solution on the copper foil surface to form an organic rust-proofing layer can be used, i.e. especially limited technology is not required as long as the solution and the copper foil surface can thoroughly contact. The concentration of the organic rust-proofing agent is not especially limited and high or low in concentration is basically no consequence.

Drying step: The purpose of the drying step is to dry a surface-treated copper foil wet in a surface treatment step such as a rust-proofing treatment. Next, when an organic agent-treatment layer is provided, a drying condition should be paid attention. That is because in the drying step, not only removing of moisture, but also fixing of the adsorbed organic rust-proofing agent or silane coupling agent .on the surface of a rust-proofing treatment layer should be performed without-decomposition of the organic substances. That is, the effect of a used organic agent should be the maximum. In view of such consideration, it is preferable to carry out the drying step at a temperature of 100°C to 250°C for 2 sec to 10 sec. Hereinafter, the surface-treated copper foil according to the present invention will be described in more detail with reference to Examples and Comparative Examples.

### [Example 1]

Example 1 was performed to make a background of the present invention that the zinc amount in zinc layer is 20 mg/m² to 1,000 mg/m² apparent by comparing to Comparative Example 1 described later. In Example 1, a surface-treated copper foil was manufactured by the following procedure and properties including tensile strength after heat treatment were measured. Hereinafter, the procedure will be described step by step.

### [Manufacturing of a surface-treated copper foil]

Copper foil: An electro-deposited copper foil of 15 µm thick manufactured by Mitsui Mining & Smelting Co., Ltd. used for manufacturing of a VLP copper foil without surface treatment was used. The electro-deposited copper foil has tensile strength as received of 55.6 kgf/mm² (545 N/mm²), and having surface roughness (Ra)at the shiny side of 0.22 µm and surface roughness (Ra) at the deposit side of 0.32 µm, a low profile surface. The copper foil used contains 19 ppm of sulfur, 55 ppm of carbon, 10 ppm of nitrogen and 54 ppm of chlorine, and sum amount of these small amount elements is 128 ppm.

Roughening treatment step: The copper foil was put in a copper plating solution of free sulfuric acid concentration of 200 g/l, copper concentration of 8 g/l and solution temperature of 35°C; and fine copper particles are deposited on the shiny side surface of the copper foil by cathodically polarizing the copper foil to electrolyze under the burning plating condition of current density of 25 A/dm².

Then, roughening treatment on the shiny side was finished by cathodically polarized the copper foil and electrolyzed in a copper plating solution of free sulfuric acid concentration of 110 g/l, copper concentration of 70 g/l and at solution temperature of 50°C under the level plating condition of current density of 25 A/dm² to prevent the copper particles from falling-off. After finishing the roughening treatment, the surface roughness (Ra) at the roughened surface was 0.35 µm, and the surface roughness (Ra) at the opposite surface was 0.32 µm.

Rust-proofing treatment step: The rust-proofing treatment employed in Example 1 was zinc rust-proofing treatment in which zinc layer was provided on both surfaces of a copper foil. In the rust-proofing treatment, as a zinc pyrophosphate plating bath, bath composition having a zinc concentration of 6 g/l, a potassium pyrophosphate concentration of 125 g/l and pH of 10.5 was employed; and the copper foil was cathodically polarized in the plating bath at solution temperature of 30°C, and current density and electrolysis time were changed to prepare three kind of zinc layers different in zinc amount shown in Table 1.

Chromate treatment step: In Example 1, a chromate-treatment layer was formed under the following condition. As the electrolysis condition of the electrolytic chromate treatment to form a chromate-treatment layer on the rust-proofing treatment layer, condition using a solution having a chromic acid concentration of 2 g/l and pH of 12 with solution temperature of 30°C and current density of .2 A/dm² was employed.

Silane coupling agent treatment step: After finishing the chromate treatment, without drying of the copper foil surface after water rinsing, a silane coupling agent aqueous solution was sprayed on the copper foil surfaces by showering to adsorb silane coupling agent on both surfaces of the surface-treated copper foil. The silane coupling agent aqueous solution was prepared to make 3-aminopropyltrimethoxysilane concentration to be 5 g/l in de-ionized water as a solvent.

Drying step: After finishing the silane coupling agent treatment, a surface-treated copper foil was finished through evaporating moisture and causing a condensation reaction of the silane coupling agent by introducing the wet surface-treated copper foil into a drying section at temperature of 150°C for 4 sec. In Example 1, surface-treated copper foils as the example specimens 1-1 to 1-3 shown in Table 1 were prepared.

Note that, a water rinsing step was appropriately provided between each step as required from the rust-proofing treatment step to the silane coupling agent treatment step described above in order to prevent carry-over of a solution in a prior treatment step to the next step.

### [Evaluation of the surface-treated copper foil]

Next, evaluation items and measurement methods will be described. Evaluation results of the example specimens 1-1 to 1-3 in Example 1 are collectively shown in Table 1 for comparison with the comparative specimen 1 according to Comparative Example 1 described later.

Amounts of small amount elements in a copper foil: Amounts of carbon and sulfur in a copper foil without surface treatment was analyzed using carbon/sulfur analyzer, EMIA-920V made by HORIBA Ltd. Amount of nitrogen was analyzed using an oxygen/nitrogen analyzer, EMGA-620 made by HORIBA Ltd. Amount of chlorine in a copper foil was analyzed by a silver chloride turbidimetry using a spectrophotometer, U-3310 made by Hitachi High-Tech Fielding Corp.

Tensile strength: The words "tensile strength" used in the present description means a value measured using a strip of copper foil specimen of 10 mm × 150 mm (gauge length: 50 mm) and at crosshead speed of 50 mm/min according to the method provided in IPC-TM-650. The tensile strength after heat treatment was measured in the same manner on the copper foil specimen after heat treatment under the condition shown in each Table followed by cooling down to a room temperature.

Deposition amount of a rust-proofing component: One surface of a surface-treated copper foil of 10 cm × 10 cm opposite to the measurement surface where zinc amount should be measured was coated with an adhesive to dissolve only a surface-treatment layer of the measurement surface in an aqueous solution having hydrochloric acid concentration of 30 mg/l and a hydrogen peroxide concentration of 20 mg/l. Then, zinc concentration in the resultant dissolved solution was quantitatively analyzed by an ICP (Inductively Coupled Plasma) atomic emission spectrometry which uses radiofrequency inductively coupled plasma as a light source; and she value obtained was converted to a deposition amount (mg/m²) per unit area of the rust-proofing component.

Surface roughness (Ra): Surface roughness (Ra) in the present description was measured using surface roughness/contour measuring instrument SEF-30D manufactured by Kosaka Lab. Ltd. according to the method provided in JIS B0601.

Measurement of a grain size: In the measurement of a grain size of a copper foil, FE gun-type scanning electron microscope (SUPRA 55VP, made by Carl Zeiss AG) equipped with an EBSD evaluation device (OIM Analysis, made by TSL Solutions Ltd.) provided with analyzer was used. Image data of a grain distribution pattern in a cross-section of the copper foil specimen prepared by suitable machining was acquired by the EBSD method using the device; and the average grain size was calculated by an analytical menu included in an EBSD analysis program (OIM Analysis, made by TSL Solutions Ltd.) using the image data. In the present measurement, an orientation difference of 5° or more was assumed as a crystal grain boundary. The conditions in scanning electron microscope observation were an acceleration voltage of 20 kV; an aperture diameter of 60 mm with high current mode and a sample inclination angle of 70°. The measurement was carried out by appropriately changing the conditions of the observation magnification, the measurement region and the step size depending on the size of the crystal grains.

### [Comparative Example 1]

In Comparative Example 1, comparative specimen 1 which has zinc amount on both surfaces of less than 20 mg/m² (each of both surfaces of the surface-treated copper foil has about 10 mg/m²) as the rust-proofing component in Example 1 was prepared. As the other manufacturing conditions were the same as in Example 1, further descriptions are omitted.

### [Comparison among Example 1 and Comparative Example 1]

Example 1 and Comparative Example 1 will be compared with reference to the following Table 1.

**[Table 1]**

| Sample | Type of Rust-Proofing | Tensile Strength: kgf/mm² (N/mm²) | | | Measured Surface | Deposition Amount (IPC Analysis): mg/mm² | |
|---|---|---|---|---|---|---|---|
| | | As Received | After Heat Treatment | | | | |
| | | | 350°C × 60 min | 400°C × 60 min | | Zn | Cr |
| Example specimen 1-1 | | 54.7 | 45.6 (447) | 41.7 (409) | Roughening Treated Side | 62.0 | 3.7 |
| | | | | | Deposited Side | 47.4 | 1.6 |
| Example specimen 1-2 | | 53.8 | 46.6 (457) | 38.9 (381) | Roughening Treated Side | 250.9 | 4.2 |
| | Zn rust-proofing | | | | Deposited Side | 203.3 | 1.8 |
| Example specimen 1-3 | | 54.2 | 48.4 (475) | 37.7 (370) | Roughening Treated Side | 493.4 | 2.5 |
| | | | | | Deposited Side | 377.2 | 2.5 |
| Comparative specimen 1 | | 54.5 | 38.5 (378) | 30.2 (296) | Roughening Treated Side | 10.8 | 1.3 |
| | | | | | Deposited Side | 9.6 | 1.0 |

As is apparent in Table 1, Example 1 and Comparative Example 1 are not different in surface roughness because the same copper foil is used. Further, the rust-proofing treatment layer of the example specimens 1-1 to 1-3 are constituted of zinc; and the zinc amount of each surface satisfies the specification of 20 mg/m² to 1,000 mg/m². In contrast the rust-proofing treatment layer of the comparative specimen 1 does not satisfy the specification of zinc amount of each surface of 20 mg/m² to 1,000 mg/m².

Next, with regard to tensile strengths of the example specimens 1-1 to 1-3 and the comparative specimen 1, tensile strengths as.received show no large difference among them. However, in tensile strengths after heat treatment, it is apparent that tensile strengths of the example specimens 1-1 to 1-3 show a much higher value than that of the comparative specimen 1. According to the result, it is apparent that the surface-treated copper foils which satisfy the specification according to the present invention show a good softening resistance performance of: "tensile strength after heat treatment at 350°C for 60 min is 40 kgf/mm² (392 N/mm²) or more"; and "tensile strength after heat treatment at 400°C for 60 min is 35 kgf/mm² (343 N/mm²) or more".

Further, the matter is also apparent in softening resistance performance of the example specimens 1-1 to 1-3 that a sufficient softening resistance performance is ensured when a rust-proofing treatment layer of a surface-treated copper foil using a "copper foil containing carbon, sulfur, chlorine or nitrogen, and having at least a sum amount of 100 ppm or more" is constituted of zinc, and further the zinc amount of each surface is 20 mg/m² to 1,000 mg/m².

### [Example 2]

Example 2 was carried out to verify the effects of small amount elements (carbon, sulfur, chlorine and nitrogen) in a copper foil and the grain size of the copper foil against softening resistance performance by comparing to Comparative Example 2.

### [Preparation of a surface-treated copper foil]

Copper foil. A copper foil used in Example 2 was an electro-deposited copper foil prepared under the following conditions. First, a sulfuric acid-based copper electrolytic solution was prepared by using a basic solution of a copper sulfate solution containing copper concentration of 80 g/l and free sulfuric acid concentration of 140 g/l, and was added with the following additives in following concentrations. The sulfuric acid-based copper electrolytic solution used for preparation of an electro-deposited copper foil as the example specimen 2 contains additives, 60.0 ppm of sodium salt of mercapto-1-propanesulfonic acid, 70.0 ppm of diallyldimethylammonium chloride polymer (made by Senka Corp., Unisense FPA100L), 7.0 ppm of N,N'-diethylthiourea, and chlorine of 60 ppm. Hydrochloric acid was used to arrange the chlorine concentration. In preparation of the electro-deposited copper foil, electro-deposited copper foil of 15 µm thick was formed by using a titanium plate as a cathode whose surface was polished with a #2000 emery paper and a DSA as an anode.

The copper foil prepared contains 350 ppm of carbon, 210 ppm of sulfur, 440 ppm of chlorine and 79 ppm of nitrogen, and sum amount of these small amount elements is 1,079 ppm. The grain size is 0.21 µm, and tensile strength as received is 80.7 kgf/mm² (791 N/mm²).

Roughening treatment step: Roughening treatment was not subjected on the copper foil, example specimen 2.

Rust-proofing treatment step: In Example 2, on the electro-deposited copper foils prepared as in the above, zinc layers having two different zinc amounts were formed by changing the zinc deposition amount as shown in Table 2.

Then, two kinds of surface-treated copper foils were prepared by subjecting to a chromate treatment step, a silane coupling agent treatment step and a drying step as in Example 1. Specimens obtained from the two kinds of surface-treated copper foils were named example specimens 2-1 and 2-2. Evaluation results on these samples are collectively shown in Table 2 for comparison with Comparative Example 2.

### [Comparative Example 2].

In Comparative Example 2, an electro-deposited copper foil having a sum amount of small amount elements in the foil of 100 ppm or less was selected to use. And the electro-deposited copper foil having a grain size of 1.0 µm or more was selected to use.

Copper foil: As a copper foil having a sum amount of small amount elements of less than 100 ppm, an electro-deposited copper foil of 15 µm thick used for manufacturing of an HTE copper foil made by Mitsui Mining & Smelting Co., Ltd. without surface treatment was used. The electro-deposited copper foil contains 34 ppm of carbon, 0 ppm of sulfur, 8 ppm of chlorine and 0 ppm of nitrogen. The sum amount of these small amount elements is 42 ppm. The grain size is 1.08 µm, and tensile strength as received is 39.3 kgf/mm² (385 N/mm²).

Then, three kinds of surface-treated copper foils were prepared by subjecting to a rust-proofing treatment step, a chromate treatment step, a silane coupling agent treatment step and a drying step as in Example 2, and were named comparative specimens 2-1, 2-2 and 2-3: As for the comparative specimen 2-1, rust-proofing treatment step was skipped to prepare a surface treated copper foil without a rust-proofing treatment layer. Evaluation results on these samples are collectively shown in Table 2 for comparison with Example 2.

**[Table 2]**

| Sample | Thickness | Grain size | Amount of Small Amount Element in Foil (ppm) | | | | | Rust-Proofing Treatment Layer | | Tensile Strength in kgf/mm² (N/mm²) | | |
|---|---|---|---|---|---|---|---|---|---|---|---|---|
| | µm | µm | Sum Amount | Carbon | Sulfur | Chlorine | Nitrogen | Rust-Proofing Component | Zn Deposition Amount mg/m² | As Received | After Heat Treatment | |
| | | | | | | | | | | | 350°C × 60 min | 400°C × 60 min |
| Example specimen 2-1 | | 0.21 | 1079 | 350 | 210 | 440 | 79 | Zn | 195 | 80.7 | 64.6 (634) | 60.1 (589) |
| Example specimen 2-2 | | | | | | | | | 539 | | 67.5 (662) | 62.8 (615) |
| Comparative specimen 2-1 | 15 | 1.08 | 42 | 34 | 0 | 8 | 0 | - | 0 | 39.3 | 18.1 (178) | 17.3 (170) |
| Comparative specimen 2-2 | | | | | | | | Zn | 52 | | 18.6 (182) | 17.7 (174) |
| Comparative specimen 2-3 | | | | | | | | | 481 | | 20.4 (200) | 18.7 (183) |
| Reference specimen | | 0.21 | 1079 | 350 | 210 | 440 | 79 | - | 0 | 80.7 | 14.9 (146) | 14.5 (142) |

### [Comparison among Example 2 and Comparative Example 2]

Comparison will be made with reference to Table 2. First, the example specimens will be described. As can be apparently understood, when zinc amount of the surface-treated copper foil increases, softening resistance performance when high heats at 350°C and 400°C are loaded is improved in proportion to the zinc amount.

When tensile strengths as received are compared, tensile strengths after heat treatment of the example specimens may show apparent high values because the values of the example specimens 2-1 and 2-2 are much higher than these of the comparative specimens 2-1 to 2-3.

However, the reference specimen in Table 2 is a sample corresponding to the example specimen 2-1 and the example specimen 2-2 except that the rust-proofing treatment layer was not provided. That is, it is apparent that even if the copper foil is the same copper foil used in the example specimen 2-1 and the example specimen 2-2, the reference specimen without zinc layer just performs equal to or lower softening resistance performance than the comparative specimens 2-1 to 2-3 when high heats at 350°C and 400°C are loaded.

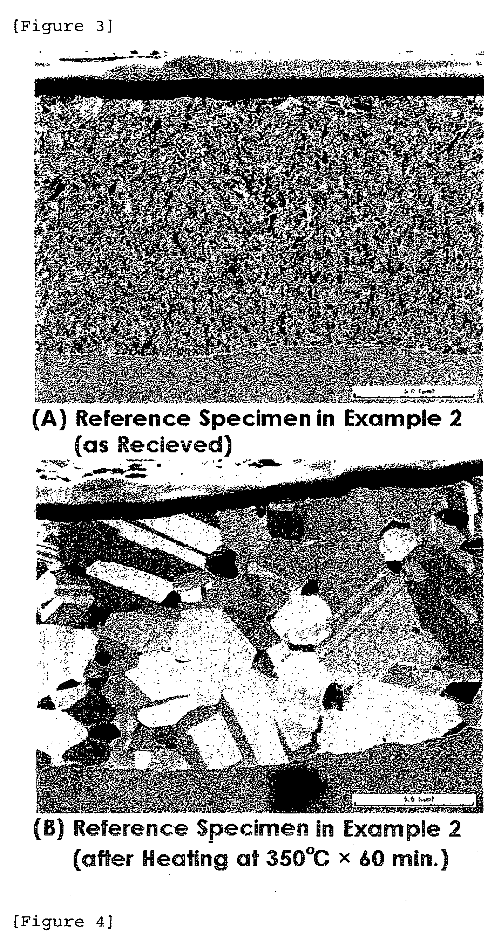

Next, the example specimens in Example 2 arid the reference specimen will be compared from the viewpoint of the grain structure. Figure 3 is an FIB-SIM image of the reference specimen disclosed in Table 2. Figure 3(A) is crystal grains as received; and grain size is 0.21 µm, and tensile strength is 80.7 kgf/mm² (791 N/mm²). Figure 3(B) is crystal grains after heat treatment at 350°C for 60 min; and grain size is 1.83 µm, and tensile strength is 14.9 kgf/mm² (146 N/mm²). That is, the reference specimen is low in softening resistance performance when heated.

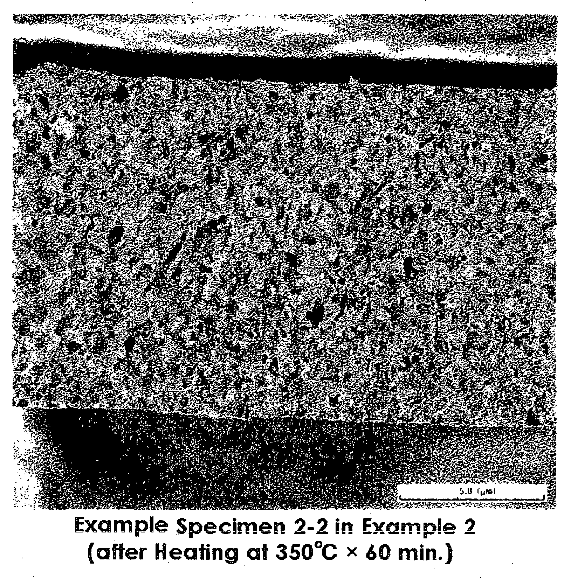

In contrast, tensile strength of the example specimen 2-2 having the zinc amount of 539 mg/m² was 67.5 kgf/mm² (662 N/mm²) after heat treatment at 350°C for 60 min, and 62.8 kgf/mm² (616 N/mm²) even after heat treatment at 400°C for 60 min; i.e. decreases in tensile strength after heat treatment in the either temperature condition are low and softening resistance performance is high. According to Figure 4 showing an FIB-SIM image of the example specimen 2-2 after heat treatment at 350°C for 60 min, the grain size is 0.31 µm, and very fine crystal grains are maintained, i.e. it can be understood that the miniaturization effect of the crystal grain is maintained in the surface-treated copper foil.

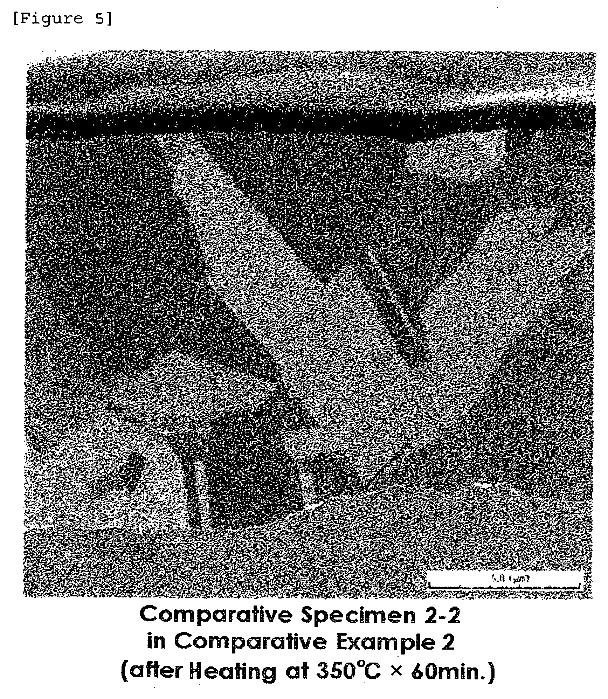

Then, effects on softening resistance performance of amount of the small amount element and the grain size of a copper foil will be investigated. In the comparative specimens 2-1 to 2-3, an electro-deposited copper foil containing a sum amount of small amount elements in the copper foil of 100 ppm or less and having a grain size as received of exceeding 1.0 µm is used. In the comparative specimen 2-2 which is an electro-deposited copper foil subjected to the rust-proofing treatment to have the zinc amount of 52 mg/m², tensile strength after heat treatment was 18.6 kgf/mm² (182 N/mm²) at 350°C for 60 min, and 17.3 kgf/mm² (170 N/mm²) at 400°C for 60 min; i.e. heat treatment in the either temperature condition remarkably decrease the tensile strength. Figure 5 is an FIB-SIM image of the comparative specimen 2-2 after heat treatment at 350°C for 60 min. The grain size is 3.48 µm and it can be understood that grain size is very large. Tensile strength of the comparative specimen 2-3 after heat treatment having a zinc amount of 481 mg/m² was 20.4 kgf/mm² (200 N/mm²) at 350°C for 60 min, and 18.7 kgf/mm² (183 N/mm²) at 400°C for 60 min; i.e. heat treatment in the either temperature condition remarkably decrease tensile strength as in the comparative specimen 2-2.

As described above, it can be understood that when the sum amount of small amount elements in a copper foil used in manufacturing of a surface-treated copper foil is 100 ppm or less, and grain size as received is exceeding 1.0 µm, even if the zinc amount of a rust-proofing treatment layer is in the range of 20 mg/m² to 1,000 mg/m², tensile strength of the surface-treated copper foil after heat treatment remarkably decreases, i.e. softening resistance performance is poor. Therefore, it is apparent that the grain size of a copper foil should be in a reasonable range in addition to an appropriate zinc amount in the rust-proofing treatment in order to improve softening resistance performance of a surface-treated copper foil.

As is apparent in comparison among Example 2 and Comparative Example 2, it is preferable to satisfy two specifications, "amount of the small amount element in the copper foil is reasonable" and "the rust-proofing layer has a reasonable zinc amount", and to satisfy further specification "the grain size as received of the copper foil is in a reasonable range" is more preferable in order to secure further improvement in softening resistance performance of an electro-deposited copper foil when high heat at 350°C and 400°C are loaded.

### [Example 3]

In Example 1 and Example 2 described above, improving effects of softening resistance performance of the surface-treated copper foil using zinc rust-proofing when high heat at 350°C and 400°C were loaded on the copper foil are demonstrated. Then, almost the same effect of a "zinc-based composite layer of a two-layer structure" will be demonstrated in Example 3. That is, samples provided with rust-proofing treatment layers including a "zinc layer", a "zinc-based composite layer of tin layer / zinc lawyer", a "zinc-based composite layer of cadmium layer / zinc layer", a "zinc-based composite layer of antimony layer / zinc layer", a "zinc-based composite layer of bismuth layer / zinc layer", and a "zinc-based composite layer of lead layer / zinc layer". were prepared in Example 3 as shown in Table 3 for comparison.

Preparation of a copper foil: In Example 3, as an electro-deposited copper foil having a sum amount of small amount elements in the copper foil of 100 ppm or more, an electro-deposited copper foil of 12 µm thick manufactured by Mitsui Mining & Smelting Co., Ltd. used for manufacturing of a VLP copper foil was used. The copper foil contains 44 ppm of carbon, 14 ppm of sulfur, 52 ppm of chlorine, and 11 ppm of nitrogen and the sum amount of these small amount elements is 121 ppm. The grain size is 0.60 µm, and tensile strength as received is 54.4 kgf/mm² (533 N/mm²).

Roughening treatment step: Roughening treatment was not subjected to the copper foil used in Example 3.

Rust-proofing treatment step: In Example 3, different metal layers were provided on each of both surfaces of a copper foil, followed by providing zinc layer on the surface of the different metal layer on each of both surfaces of the copper foil, as in Example 1. So, just formation condition of different metal layer corresponding to the kind of a rust-proofing treatment layer will be described. The amount of the different metal of different metal layers and the zinc deposition amounts provided on both surfaces of the copper foil were made to be identical.

Zinc-based composite layer composed of tin layer / zinc layer was formed on the surface of a copper foil using tin plating solution having a composition of pH 10.0, tin pyrophosphate concentration of 11 g/l and a potassium pyrophosphate concentration of 100 g/l, and tin layer was formed under the condition of solution temperature of 40°C, and current density of 1.0 A/dm² followed by providing zinc layer as in Example 1 to finish zinc-based composite layer of a two-layer structure. In Table 3, the present sample is named example specimen 3-3.

Zinc-based composite layer composed of cadmium layer / zinc layer was formed on the surface of a copper foil using cadmium plating solution having a composition of cadmium sulfate concentration of 50 g/l and a sulfuric acid concentration of 50 g/l, and cadmium layer was formed under the condition of solution temperature of 40°C, and current density of 0.5 A/dm², followed by providing zinc layer as in Example 1 to finish zinc-based composite layer of a two-layer structure. In Table 3, the present sample is named example specimen 3-4.

. Zinc-based composite layer composed of antimony layer / zinc layer was formed on the surface of a copper foil using antimony plating solution having a composition of pH 2.1, a potassium antimonyl tartrate concentration of 50 g/l, a formic acid concentration of 12.5 g/l and a potassium chloride concentration of 25 g/l, and antimony layer was formed under the condition of solution temperature of 40°C and current density of 0.5 A/dm², followed by providing zinc layer as in Example 1 to finish zinc-based composite layer of a two-layer structure. In Table 3, the present sample is named example specimen 3-5.

Zinc-based composite layer composed of bismuth layer / zinc layer was formed on the surface of a copper foil using bismuth plating solution having a composition of pH 12.5, bismuth sulfate concentration of 8.5 g/l, a citric acid concentration of 190 g/l and a sodium hydroxide concentration of 140 g/l, and bismuth layer was formed under the condition of solution temperature of 40°C and current density of 0.1 A/dm², followed by providing zinc layer as in Example 1 to finish zinc-based composite layer of a two-layer structure. In Table 3, the present sample is named example specimen 3-6.

Zinc-based composite layer composed of lead layer / zinc layer was formed on the surface of a copper foil using lead plating solution having a composition of lead oxide concentration of 90 g/l and a fluorosilicic acid concentration of 120 g/l, and lead plating layer was formed under the condition of a bath temperature of 30°C, and current density of 0.5 A/dm², followed by providing zinc layer as in Example 1. In Table 3, the present sample is named example specimen 3-7.

After finishing rust-proofing treatment described above, the rust-proofing treated copper foils were subjected to a chromate treatment step, a silane coupling agent treatment step and a drying step as in Example 1 to prepare surface-treated copper foils corresponding to the example specimens 3-1 to 3-7. Evaluation results on these samples are collectively shown in Table 3 for comparison with Comparative Example 3.

### [Comparative Example 3]

In Comparative Example 3, a surface-treated copper foil was prepared by the same procedure as in Example 3, using an electro-deposited copper foil which was used for manufacturing of a VLP copper foil used in Example 3 without subjecting to rust-proofing treatment, and was named comparative specimen 3. Evaluation results are collectively shown in Table 3 for comparison with Example 3.

### [Comparison among Example 3 and Comparative Example 3]

Comparison will be made with reference to Table 3.

**[Table 3]**

| sample | Thickness | Grain Size | Amount of Small Amount Element in Foil (ppm) | | | | | Rust-Proofing Treatment Layer | | Tensile Strength in kgf/mm² (N/mm²) | | |
|---|---|---|---|---|---|---|---|---|---|---|---|---|
| | µm | µm | Sum Amount | Carbon | Sulfur | Chlorine | Nitrogen | Rust-proofing Proofing Component | Deposition Amount(mg/m²) | As Received | After Heat Treatment | |
| | | | | | | | | | | | 350°C × 60 min | 400°C × 60 min |
| Example specimen 3-1 | | | | | | | | Zn | Zn:45 | | 47.7 (468) | 43.8 (430) |
| Example specimen 3-2 | | | | | | | | | Zn:457 | | 41.4 (405) | 35.0 (343) |
| Example specimen 3-3 | | | | | | | | Sn/Zn | [Sn : 7]/[Zn : 66] | | 50.6 (496) | 44.2 (433) |
| Example specimen 3-4 | 12 | 0.60 | 121 | 44 | 14 | 52 | 11 | Cd/Zn | [Cd: 37]/[Zn : 235] | 54.4 | 50.9 (499) | 41.0 (402) |
| Example specimen 3-5 | | | | | | | | Sb/Zn | [Sb : 19)/[Zn : 260] | | 53.2 (522) | 52.0 (510) |
| Example specimen 3-6 | | | | | | | | Bi/Zn | [Bi: 23/][Zn : 254] | | 54.7 (536) | 53.2 (522) |
| Example specimen 3-7 | | | | | | | | Pb/Zn | [Pb : 3]/[Zn : 245] | | 52.0 (510) | 41.4 (406) |
| Comparative specimen 3 | | | | | | | | - | 0 | | 37.5 (368) | 32.5 (319) |

The example specimens 3-3 to 3-7 in Table 3 employ a "zinc-based composite layer of a two-layer structure" as their rust-proofing treatment layer. The matter can be understood that softening resistance performance of the electro-deposited copper foil when high heat of 350°C or 400°C was loaded is improved also in the case where the zinc-based composite layer of a two-layer structure is used as a rust-proofing treatment layer. Further, even if.the zinc amount fluctuates in a range exceeding 50 mg/m², softening resistance performance after heat treatment at both 350°C for 60 min and at 400°C for 60 min tends to stabilize.

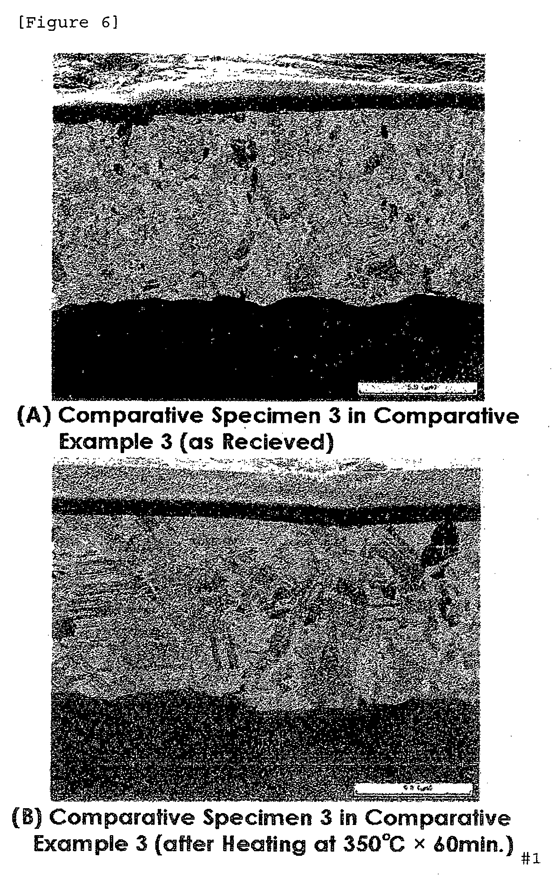

Next, the grain structures in Example 3 and Comparative Example 3 will be compared. Figure 6 is an FIB-SIM image of the comparative specimen 3 prepared in Comparative Example 3 in which the surface-treated copper foil was prepared without rust-proofing treatment. The grain size as received shown in Figure 6 (A) is 0.60 µm, and tensile strength is 54.4 kgf/mm² (533 N/mm²). The grain size after heat treatment at 350°C for 60 min shown in Figure 6(B) is 0.92 µm, and tensile strength thereafter is 37.5 kgf/mm² (368 N/mm²).

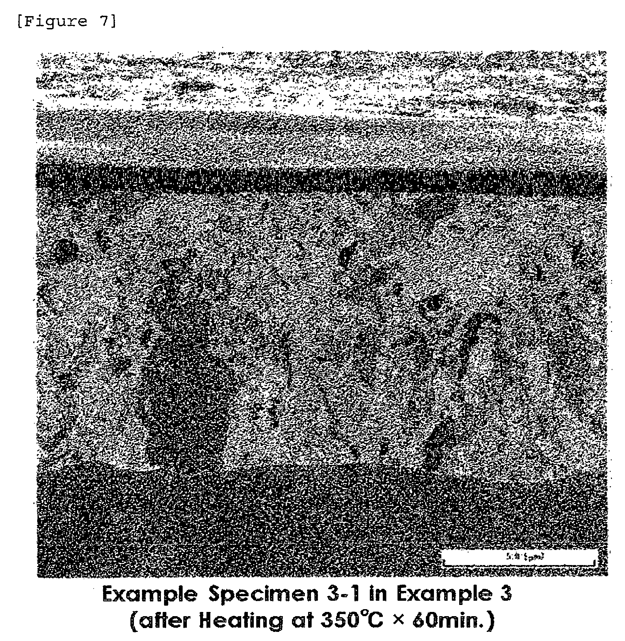

In contrast, Figure 7 shows an FIB-SIM image of the example specimen 3-1 after heat treatment at 350°C for 60 min when the surface-treated copper foil was prepared with the zinc amount of 50 mg/m². As can be understood from Figure 7, the crystal grains are maintained fine. The grain size is 0.74 µm, and tensile strength is 47.7 kgf/mm² (468 N/mm²). It is apparent that when a surface-treated copper foil is prepared in such a manner with the zinc amount being 50 mg/m², the grain structure after heat treatment is fine and the decrease in tensile strength can be hindered.

That is, it is made apparent that without zinc rust-proofing treatment layer, heat treatment at 350°C for 60 min promotes re-crystallization to grow crystal grains. Therefore, it can be judged that, miniaturization effect of the crystal grains is maintained to hinder decrease in tensile strength because zinc in the zinc rust-proofing treatment layer employed in the present invention inhibits the re-crystallization of the copper foil grain structure when heated.

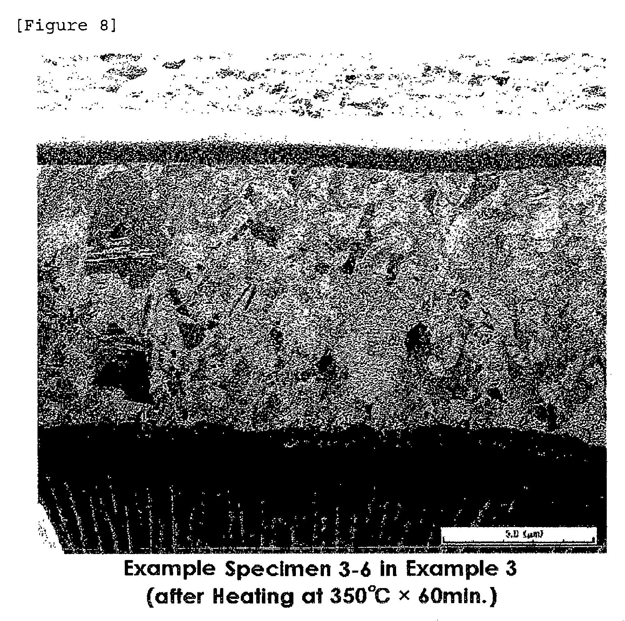

Figure 8 shows an FIB-SIM image of the grain structure of the example specimen 3-6 after heat treatment at 350°C for 60 min which is provided with the zinc-based composite layer of a two-layer structure (bismuth layer / zinc layer, bismuth deposition amount: 23 mg/m², zinc amount: 254 mg/m²) as a rust-proofing treatment layer. As can be understood from Figure 8, the grain structure is remarkably fine. Tensile strength of the surface-treated copper foil is 54.7 kgf/mm² (536 N/mm²), i.e. the effect of the miniaturization of crystal grain is maintained and softening resistance performance when high heat is loaded is excellent.

### [Summary of comparisons among Examples and Comparative Examples]

From above results in comparisons, when the copper foil which satisfies ground specification of a "copper foil containing carbon, sulfur, chlorine or nitrogen and having at least a sum amount thereof of 100 ppm or more" is used, satisfying the specification of "being constituted of zinc or zinc-based composite layer of a two-layer structure, and having a zinc amount of 20 mg/m² to 1,000 mg/m²" is indispensable for a rust-proofing treatment layer provided on each of both surfaces of the copper foil in order to improve softening resistance performance when high heat is loaded on a surface-treated copper foil. The deposition amount of different metal component when zinc-based composite layer of a two-layer structure is employed is preferable to be 1 mg/m² to 200 mg/m². It can be understood that when the above-mentioned specifications are satisfied, a good softening resistance performances, "tensile strength of 40 kgf/mm² (392, N/mm²) or more after heat treatment at 350°C for 60 min" and "tensile strength of 35 kgf/mm² (343 N/mm²) or more after heat treatment at 400°C for 60 min" can be provided in the surface-treated copper foil.

### [Industrial Applicability]

The surface-treated copper foil according to the present invention shows a good softening resistance performance even if high heat is loaded on the surface treated copper foil. Therefore, the surface treated copper foil is suitable in applications such as printed wiring boards and negative electrode current collectors of lithium ion secondary batteries. The reason is that the life of products can be elongated and the quality is stabilized because the decrease of tensile strength of the surface-treated copper foil according to the present invention after heat treatment is low even though the surface-treated copper foil used in the manufacturing processes of these products may be exposed to high heat. In addition, as the manufacturing of the surface-treated copper foil according to the present invention can utilize existing copper foil-manufacturing facilities and does not require new facility investments, the effective utilization of copper foil manufacture facilities as a social capital is made possible.

### [Symbol List]

- 1: SURFACE-TREATED COPPER FOIL
- 2: COPPER FOIL LAYER
- 3: RUST-PROOFING TREATMENT LAYER
- 4: CHROMATE-TREATMENT LAYER
- 5: ORGANIC AGENT-TREATMENT LAYER
- 6: ROUGHENING TREATMENT LAYER (FINE COPPER PARTICLES)

## Claims

1. A surface-treated copper foil provided with a rust-proofing treatment layer on both surfaces of a copper foil,
wherein the copper foil contains one or two or more of small amount elements selected from carbon, sulfur, chlorine and nitrogen, and a sum amount thereof is 100. ppm or more,
**characterized in that** the rust-proofing treatment layer is constituted by zinc, and the rust proofing treatment layer on each surface is a zinc layer having a zinc amount of 20 mg/m² to 1,000 mg/m².

2. The surface-treated copper foil according to claim 1, wherein the sum amount of zinc constituting the zinc layers provided on both surfaces of the copper foil is 40 mg/m² to 2,000 mg/m².

3. The surface-treated copper foil according to claim 1 or 2, wherein the rust-proofing treatment layer is constituted by a zinc-based composite layer of a two-layer structure provided with a different metal layer selected from tin layer, cadmium layer, antimony layer, bismuth layer, indium layer and lead layer between the copper foil and the zinc layer, or on a surface of the zinc layer.

4. The surface-treated copper foil according to claim 3, wherein the different metal layer is the layer containing the different metal component of 1 mg/m² to 200 mg/m².

5. The surface-treated copper foil according to any one of claims 1 to 4, wherein the copper foil is an electro-deposited copper foil having a grain size as received of 1.0 µm or less.

6. The surface-treated copper foil according to any one of claims 1 to 5, wherein the copper foil is an electro-deposited copper foil having tensile strength as received of 50 kgf/mm² (490 N/mm²) or more.

7. The surface-treated copper foil according to any one of claims 1 to 6, wherein the copper foil is provided with a roughening treatment on one surface or both surfaces.

8. The surface-treated copper foil according to any one of claims 1 to 7, wherein the rust-proofing treatment layer is provided with one or both of a chromate-treatment layer and an organic agent-treatment layer on a surface.

9. The surface-treated copper foil according to claim 8, wherein the organic agent-treatment layer is one or both of a silane coupling agent-treatment layer and an organic rust-proofing treatment layer.

10. The surface-treated copper foil according to any one of claims 1 to 9, wherein the surface roughness (Ra) of the surface treated copper foil is 0.1 µm to 0.7 µm.

11. The surface-treated copper foil according to any one of claims 1 to 10, wherein the tensile strength of the surface-treated copper foil after heat treatment at 350°C for 60 min in an inert gas atmosphere is 40 kgf/mm² (392 N/mm²) or more.

12. The surface-treated copper foil according to any one of claims 1 to 11, wherein the tensile strength of the surface-treated copper foil after heat treatment at 400°C for 60 min in an inert gas atmosphere is 35 kgf/mm² (343 N/mm²) or more.

## Patentansprüche

1. Eine oberflächenbehandelte Kupferfolie, die mit einer Rostschutzbehandlungsschicht auf beiden Oberflächen einer Kupferfolie versehen ist,
wobei die Kupferfolie eines oder zwei oder mehr Elemente in geringer Menge, ausgewählt aus Kohlenstoff, Schwefel, Chlor und Stickstoff, enthält, und eine Gesamtmenge derselben 100 ppm oder mehr beträgt,
**dadurch gekennzeichnet, dass** die Rostschutzbehandlungsschicht aus Zink gebildet ist und die Rostschutzbehandlungsschicht auf jeder Oberfläche eine Zinkschicht mit einer Zinkmenge von 20 mg/m² bis 1000 mg/m² ist.

2. Die oberflächenbehandelte Kupferfolie nach Anspruch 1, wobei die Gesamtmenge an Zink, das die Zinkschichten bildet, die auf beiden Oberflächen der Kupferfolie bereitgestellt sind, 40 mg/m² bis 2000 mg/m² beträgt.

3. Die oberflächenbehandelte Kupferfolie nach Anspruch 1 oder 2, wobei die Rostschutzbehandlungsschicht aus einer Verbundschicht auf Zinkbasis mit einer Zweischichtstruktur gebildet ist, die mit einer anderen Metallschicht, ausgewählt aus einer Zinnschicht, Cadmiumschicht, Antimonschicht, Wismutschicht, Indiumschicht und Bleischicht, zwischen der Kupferfolie und der Zinkschicht oder auf einer Oberfläche der Zinkschicht versehen ist.

4. Die oberflächenbehandelte Kupferfolie nach Anspruch 3, wobei die andere Metallschicht die Schicht ist, die den anderen Metallbestandteil in 1mg/m² bis 200 mg/m² enthält.

5. Die oberflächenbehandelte Kupferfolie nach einem der Ansprüche 1 bis 4, wobei die Kupferfolie eine galvanisch abgeschiedene Kupferfolie mit einer erhaltenen Korngröße von 1,0 µm oder weniger ist.

6. Die oberflächenbehandelte Kupferfolie nach einem der Ansprüche 1 bis 5, wobei die Kupferfolie eine galvanisch abgeschiedene Kupferfolie mit einer erhaltenen Zugfestigkeit von 50 kgf/mm² (490 N/mm²) oder mehr ist.

7. Die oberflächenbehandelte Kupferfolie nach einem der Ansprüche 1 bis 6, wobei die Kupferfolie mit einer Aufrauungsbehandlung auf einer Oberfläche oder beiden Oberflächen versehen ist.

8. Die oberflächenbehandelte Kupferfolie nach einem der Ansprüche 1 bis 7, wobei die Rostschutzbehandlungsschicht auf einer Oberfläche mit einer oder beiden aus einer Chromatbehandlungsschicht und einer Schicht einer Behandlung mit einem organischen Mittel versehen ist.

9. Die oberflächenbehandelte Kupferfolie nach Anspruch 8, wobei die Schicht einer Behandlung mit einem organischen Mittel eine oder beide aus einer Silankupplungsmittel-Behandlungsschicht und einer organischen Rostschutzbehandlungsschicht ist.

10. Die oberflächenbehandelte Kupferfolie nach einem der Ansprüche 1 bis 9, wobei die Oberflächenrauigkeit (Ra) der oberflächenbehandelten Kupferfolie 0,1 µm bis 0,7 µm beträgt.

11. Die oberflächenbehandelte Kupferfolie nach einem der Ansprüche 1 bis 10, wobei die Zugfestigkeit der oberflächenbehandelten Kupferfolie nach Wärmebehandlung bei 350°C für 60 min. in einer Inertgasatmosphäre 40 kgf/mm² (392 N/mm²) oder mehr beträgt.

12. Die oberflächenbehandelte Kupferfolie nach einem der Ansprüche 1 bis 11, wobei die Zugfestigkeit der oberflächenbehandelten Kupferfolie nach Wärmebehandlung bei 400°C für 60 min. in einer Inertgasatmosphäre 35 kgf/mm² (343 N/mm²) oder mehr beträgt.

## Revendications

1. Feuille de cuivre traitée en surface pourvue d'une couche de traitement antirouille sur les deux surfaces d'une feuille de cuivre,
la feuille de cuivre contenant un ou deux éléments en faibles quantités ou plus choisis parmi le carbone, le soufre, le chlore et l'azote, et dont une quantité totale est supérieure ou égale à 100 ppm,
**caractérisée en ce que** la couche de traitement antirouille est constituée de zinc, et la couche de traitement antirouille sur chaque surface est une couche de zinc ayant une quantité de zinc de 20 mg/m² à 1000 mg/m².

2. Feuille de cuivre traitée en surface selon la revendication 1, dans laquelle la quantité totale de zinc constituant les couches de zinc disposées sur les deux surfaces de la feuille de cuivre va de 40 mg/m² à 2000 mg/m².

3. Feuille de cuivre traitée en surface selon la revendication 1 ou 2, dans laquelle la couche de traitement antirouille est constituée d'une couche composite à base de zinc d'une structure à deux couches pourvue d'une couche de métal différent choisie parmi une couche d'étain, une couche de cadmium, une couche d'antimoine, une couche de bismuth, une couche d'indium et une couche de plomb entre la feuille de cuivre et la couche de zinc, ou sur une surface de la couche de zinc.

4. Feuille de cuivre traitée en surface selon la revendication 3, dans laquelle la couche de métal différent est la couche contenant le composant métallique différent de 1 mg/m² à 200 mg/m².

5. Feuille de cuivre traitée en surface selon l'une quelconque des revendications 1 à 4, dans laquelle la feuille de cuivre est une feuille de cuivre déposée par voie galvanique ayant une grosseur de grain à sa réception inférieure ou égale à 1,0 µm.

6. Feuille de cuivre traitée en surface selon l'une quelconque des revendications 1 à 5, dans laquelle la feuille de cuivre est une feuille de cuivre déposée par voie galvanique ayant une résistance à la traction à sa réception supérieure ou égale à 50 kgf/mm² (490 N/mm²).

7. Feuille de cuivre traitée en surface selon l'une quelconque des revendications 1 à 6, dans laquelle la feuille de cuivre fait l'objet d'un traitement de rugosification sur une surface ou les deux surfaces.

8. Feuille de cuivre traitée en surface selon l'une quelconque des revendications 1 à 7, dans laquelle la couche de traitement antirouille est pourvue d'une ou des deux d'une couche de traitement de chromate et d'une couche de traitement d'agent organique sur une surface.

9. Feuille de cuivre traitée en surface selon la revendication 8, dans laquelle la couche de traitement d'agent organique est l'une ou les deux d'une couche de traitement d'agent de couplage au silane et d'une couche de traitement antirouille organique.

10. Feuille de cuivre traitée en surface selon l'une quelconque des revendications 1 à 9, dans laquelle la rugosité de surface (Ra) de la feuille de cuivre traitée en surface va de 0,1 µm à 0,7 µm.

11. Feuille de cuivre traitée en surface selon l'une quelconque des revendications 1 à 10, dans laquelle la résistance à la traction de la feuille de cuivre traitée en surface après traitement thermique à 350°C pendant 60 min. dans une atmosphère de gaz inerte est supérieure ou égale à 40 kgf/mm² (392 N/mmµ).

12. Feuille de cuivre traitée en surface selon l'une quelconque des revendications 1 à 11, dans laquelle la résistance à la traction de la feuille de cuivre traitée en surface après traitement thermique à 400°C pendant 60 min dans une atmosphère de gaz inerte est supérieure ou égale à 35 kgf/mm² (343 N/mm²).
